(19) Europäisches Patentamt
European Patent Office
Office européen des brevets

(11) EP 4 495 614 B1

(12) **EUROPEAN PATENT SPECIFICATION**

(45) Date of publication and mention of the grant of the patent:
**06.05.2026 Bulletin 2026/19**

(21) Application number: **23904089.2**

(22) Date of filing: **15.12.2023**

(51) International Patent Classification (IPC):
***G01R 31/389*** *(2019.01)* ***G01R 31/392*** *(2019.01)*
***G01R 31/367*** *(2019.01)*

(52) Cooperative Patent Classification (CPC):
**G01R 31/392; G01R 31/367; G01R 31/389;**
Y02E 60/10

(86) International application number:
**PCT/KR2023/095120**

(87) International publication number:
**WO 2024/128890 (20.06.2024 Gazette 2024/25)**

(54) **BATTERY INSPECTION METHOD**

BATTERIEPRÜFVERFAHREN

PROCÉDÉ D'INSPECTION DE BATTERIE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **15.12.2022 KR 20220175754**

(43) Date of publication of application:
**22.01.2025 Bulletin 2025/04**

(73) Proprietor: **LG Energy Solution, Ltd.**
**Seoul 07335 (KR)**

(72) Inventors:
- **HEO, Yeonhyuk**
  **Daejeon 34122 (KR)**
- **KIM, Kwanghyun**
  **Daejeon 34122 (KR)**
- **CHAE, Byung Joon**
  **Daejeon 34122 (KR)**
- **RAH, Kyun Il**
  **Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(56) References cited:
**CN-A- 111 505 512**
**CN-A- 112 763 545**
**KR-A- 20190 118 535**
**KR-A- 20200 122 903**
**KR-A- 20220 068 806**
**US-A1- 2012 019 253**
**US-A1- 2017 219 660**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 495 614 B1

## Description

### Technical Field

The present application claims the benefit of priority based on Korean Patent Application No. 10-2022-0175754 filed on December 15, 2022.

The present disclosure relates to a battery inspection method, and relates to a battery inspection method which is capable of identifying cracks in electrodes of a completed secondary battery by non-destructive testing.

### Background Art

US 2017/219660 A1 describes a method of determining the State of Health (SoH) and/or State of Charge (SoC) of a rechargeable battery during use of said battery. The method comprises the steps of: generating a first excitation signal within a first selected frequency range, generating a second excitation signal within a second selected frequency range, applying said first and second excitation signals on said rechargeable battery, measuring the response signal for each of said two excitation signals, and then calculate the Electrochemical Impedance (EI) as the ratio between the excitation signals and respective response signals, and then determine the SoH and/or SoC of the rechargeable battery by comparing the calculated EI to a circuit model for the battery and/or determining the SoH and/or SoC of the rechargeable battery by directly evaluating characteristics of the EI.

After shipment of an initial cell, one of various phenomena that occur as a secondary battery degenerates due to progress of high-temperature storage, a charge-discharge cycle, and the like, is occurrence of microcracks in electrodes.

It is important to identify the microcracks that occur in the electrodes because they can affect not only the performance and lifespan of the battery, but also its durability and safety. In addition, if the microcracks can be identified in a battery in use, it is possible to predict a maintenance cycle and future performance related to the battery, so analyzing them may serve as powerful data in battery operation.

Conventionally, as a technique for identifying cracks in the electrodes, it is possible to quantify the cracks in the electrodes by analyzing an electron microscope image of the electrodes. However, since analysis of the phenomenon of occurrence of cracks in the electrodes through electron microscopy is carried out by completely disassembling the battery and extracting the electrodes from the battery, there is a problem in that the battery in which the analysis has been performed should be discarded. In other words, it was not possible to monitor a state of occurrence of cracks of the electrodes of the battery during use using the electron microscopy method.

**In** addition, since a process of preparing an analysis sample was cumbersome and measurement took a long time, the electron microscopy method had problems with its use as immediate feedback data.

Therefore, there is a need for a technology that can be applied to a battery in use as non-destructive analysis and that can perform analysis in a short period of time to immediately monitor the phenomenon of occurrence of cracks in electrodes of the battery.

### Disclosure of the Invention

### Technical Goals

The present disclosure relates to a battery inspection method, and an object of the present disclosure is to provide a battery inspection method which is capable of identifying cracks in electrodes of a completed secondary battery by non-destructive testing.

Technical objects to be accomplished by the present disclosure are not limited to the technical objects mentioned above, and other technical objects not mentioned may be clearly understood by those skilled in the art to which the present disclosure pertains from the following description.

### Technical Solutions

The present invention is defined according to the subject matter of the appended independent claim. Particular embodiments are given by the additional features of the appended dependent claims.

A battery inspection method of the present disclosure includes:

a data acquisition step S10 of acquiring impedance spectral data for a secondary battery;
a first function acquisition step S20 of acquiring, through function fitting, a first function which uses a logarithmic scale of a measurement frequency as an independent variable and an absolute value of impedance as a dependent variable from the impedance spectral data;

a second function acquisition step S30 of acquiring a second function by differentiating the first function by the logarithmic scale of the measurement frequency; and
a battery state determination step S40 of determining a state of the secondary battery based on the second function.

In the data acquisition step S10 of the battery inspection method of the present disclosure, the impedance spectral data may be acquired by applying alternating current power to the secondary battery for a band of the measurement frequency including a band of $10^{-2}$ Hz to $10^{5}$ Hz.

Advantageous Effects

According to a battery inspection method of the present disclosure, it is possible to identify cracks in electrodes of a completed secondary battery by non-destructive testing.
The battery inspection method of the present disclosure is applicable to a battery in use as non-destructive analysis, and it is possible to monitor the phenomenon of occurrence of cracks in the electrodes of the battery immediately by performing the analysis in a short time.
According to the battery inspection method of the present disclosure, it is possible to inspect a state of occurrence of microcracks in the electrodes of the battery in about seven (7) minutes without destroying the battery.

Brief Description of Drawings

FIG. 1 is a block diagram illustrating a battery inspection method of the present disclosure.
FIG. 2 is a graph illustrating an imaginary part of impedance and a second function for a secondary battery of Example 1.
FIG. 3 is a graph illustrating an imaginary part of impedance and a second function for a secondary battery of Example 2.
FIG. 4 is a graph illustrating an imaginary part of impedance and a second function for a secondary battery of Example 3.

Best Mode for Carrying Out the Invention

A battery inspection method of the present disclosure includes:

a data acquisition step S10 of acquiring impedance spectral data for a secondary battery;
a first function acquisition step S20 of acquiring, through function fitting, a first function which uses a logarithmic scale of a measurement frequency as an independent variable and an absolute value of impedance as a dependent variable from the impedance spectral data;
a second function acquisition step S30 of acquiring a second function by differentiating the first function by the logarithmic scale of the measurement frequency; and
a battery state determination step S40 of determining a state of the secondary battery based on the second function.

In the data acquisition step S10 of the battery inspection method of the present disclosure, the impedance spectral data may be acquired by applying alternating current power to the secondary battery for a band of the measurement frequency including a band of $10^{-2}$ Hz to $10^{5}$ Hz.
In the first function acquisition step S20 of the battery inspection method of the present disclosure, the first function may be acquired in the form of the following Equation 1.

[Equation 1]

$$Z_{abs} = F_1(\log f)$$

$Z_{abs}$ is the absolute value of the impedance, $F_1$(logf) is the first function, and f is the measurement frequency.
In the battery inspection method of the present disclosure, the second function may be acquired in the form of the following Equation 2.

[Equation 2]

$$F_2(\log f) = \frac{dZ_{abs}}{d\log f}$$

$F_2$(logf) is the second function.

In the battery state determination step S40 of the battery inspection method of the present disclosure, the state of the secondary battery may be determined based on the second function in a range where the logf is 0 to 1.

In the battery state determination step S40 of the battery inspection method of the present disclosure, when an inflection point exists in the second function in the range where the logf is 0 to 1, it may be determined that cracks occur in electrodes of the secondary battery.

In the secondary battery measured by the battery inspection method of the present disclosure, no inflection point exists in the second function in the range where the logf is 0 to 1.

Modes for Carrying Out the Invention

Hereinafter, embodiments according to the present disclosure will be described in detail with reference to the accompanying drawings. In this process, the size or shape of the components shown in the drawings may be exaggerated for clarity and convenience of explanation. In addition, terms specifically defined in consideration of the configuration and operation of the present disclosure may vary according to the intentions or customs of users and operators. Definitions of these terms should be made based on the content throughout this specification.

FIG. 1 is a block diagram illustrating a battery inspection method of the present disclosure. FIG. 2 is a graph illustrating an imaginary part of impedance and a second function for a secondary battery of Example 1. FIG. 3 is a graph illustrating an imaginary part of impedance and a second function for a secondary battery of Example 2. FIG. 4 is a graph illustrating an imaginary part of impedance and a second function for a secondary battery of Example 3.

Hereinafter, with reference to FIGS. 1 to 4, a battery inspection method of the present disclosure will be described in detail.

The battery inspection method of the present disclosure may non-destructively analyze whether cracks occur in electrodes accommodated within a secondary battery case without opening the case.

A secondary battery to be analyzed by the battery inspection method of the present disclosure may include an electrode manufactured by applying an electrode slurry to a metal substrate (a metal foil, etc.) and then drying it. The electrode slurry may be obtained by mixing an electrode active material, a conductive material, a binder, and a solvent and then kneading the mixture. The battery inspection method of the present disclosure may be able to determine whether a crack occurs in the dried electrode slurry.

As shown in FIG. 1, the battery inspection method of the present disclosure may include:

- a data acquisition step S10 of acquiring impedance spectral data for a secondary battery;
- a first function acquisition step S20 of acquiring, through function fitting, a first function which uses a logarithmic scale of a measurement frequency as an independent variable and an absolute value of impedance as a dependent variable from the impedance spectral data;
- a second function acquisition step S30 of acquiring a second function by differentiating the first function by the logarithmic scale of the measurement frequency; and
- a battery state determination step S40 of determining a state of the secondary battery based on the second function.

In the data acquisition step S10, the impedance spectral data may be acquired by electrochemical impedance spectroscopy (EIS). In other words, by applying alternating current power for a plurality of measurement frequencies and performing measurement with a voltmeter and an ammeter, an impedance value may be acquired for each of the plurality of measurement frequencies. In the data acquisition step S10 of the battery inspection method of the present disclosure, the impedance spectral data may be acquired by applying alternating current power to the secondary battery for a band of the measurement frequency including a band of $10^{-2}$ Hz to $10^5$ Hz. More preferably, the impedance spectral data may be acquired by applying alternating current power to the secondary battery for a band of the measurement frequency including a band of $10^0$ Hz to $10^1$ Hz.

The alternating current power may be applied by connecting negative and positive leads of the secondary battery to negative and positive terminals of a measurement and power supply device, respectively.

In the data acquisition step S10, the impedance value corresponding to each of the plurality of measurement frequencies may be acquired.

In the first function acquisition step S20, the first function may be acquired in the form of the following Equation 1.

[Equation 1]

$$Z_{abs} = F_1(\log f)$$

$Z_{abs}$ is an absolute value of the impedance, $F_1$(logf) is the first function, and f is the measurement frequency.

The second function may be acquired in the form of the following Equation 2.

[Equation 2]

$$F_2(\log f) = \frac{dZ_{abs}}{d\log f}$$

$F_2$(logf) is the second function.

In the battery state determination step S40, the state of the secondary battery may be determined based on the second function in a range where the logf is 0 to 1. In other words, based on the impedance value at low frequency from 1 Hz to 10 Hz, the battery inspection method of the present disclosure may determine whether cracks occur in the electrodes of the battery.

In the battery state determination step S40, when an inflection point exists in the second function in the range where the logf is 0 to 1, it may be determined that cracks occur in the electrodes of the secondary battery. Therefore, the secondary battery in which there is no inflection point in the second function in the range where the logf is 0 to 1 may be determined to be a secondary battery in a normal state with no cracks in the electrodes.

## Example 1

For a secondary battery immediately after production, EIS was performed twice with measurement frequencies in the band of $10^{-2}$ Hz to $10^{5}$ Hz, and two sets of impedance spectral data were acquired.

After calculating the absolute value for the impedance corresponding to each measurement frequency, the first function was acquired as a fitting function using the log scale of the measurement frequency as the independent variable and the absolute value of impedance as the dependent variable.

The acquired first function was differentiated by the logarithmic scale of the measurement frequency to acquire the second function.

## Example 2

For a secondary battery with 28.4% cracks formed in its electrodes, EIS was performed twice with measurement frequencies in the band of $10^{-2}$ Hz to $10^{5}$ Hz to acquire two sets of impedance spectral data.

After calculating the absolute value for the impedance corresponding to each measurement frequency, the first function was acquired as a fitting function using the log scale of the measurement frequency as the independent variable and the absolute value of impedance as the dependent variable.

The acquired first function was differentiated by the logarithmic scale of the measurement frequency to acquire the second function.

## Example 3

For a secondary battery with 27.4% cracks formed in its electrodes, EIS was performed twice with measurement frequencies in the band of $10^{-2}$ Hz to $10^{5}$ Hz to acquire two sets of impedance spectral data.

After calculating the absolute value for the impedance corresponding to each measurement frequency, the first function was acquired as a fitting function using the log scale of the measurement frequency as the independent variable and the absolute value of impedance as the dependent variable.

The acquired first function was differentiated by the logarithmic scale of the measurement frequency to acquire the second function.

In each of Examples 2 and 3, the crack % may be a value calculated by analyzing an image obtained by measuring with an electron microscope after destroying the battery after performing an electrode inspection method.

In each of FIGS. 2 to 4, the solid line is a graph for an imaginary part of the impedance, and the dashed line is a graph for the second function.

As shown in FIG. 2, the secondary battery in the normal state with no cracks has almost no curve in the range where the logf is 0 to 1. As shown in FIGS. 3 and 4, it can be seen that the graph of the second function in each of FIGS. 3 and 4 includes an inflection point in the range where the logf is 0 to 1, while the graph of the imaginary part shows no significant change.

In other words, the battery inspection method of the present disclosure may determine with high sensitivity whether cracks occur in the electrodes of the battery through the second function. In addition, since measurement may only be performed in the range where the logf is 0 to 1, cracks may be identified in a short time.

Although the embodiments of the present disclosure have been described above, they are merely illustrative, and those skilled in the art will understand that various modifications and embodiments are possible therefrom. Accordingly, the true technical scope of protection of the present disclosure should be determined by the appended claims.

Industrial Applicability

According to a battery inspection method of the present disclosure, it is possible to identify cracks in electrodes of a completed secondary battery by non-destructive testing.

The battery inspection method of the present disclosure is applicable to a battery in use as non-destructive analysis, and it is possible to monitor the phenomenon of occurrence of cracks in the electrodes of the battery immediately by performing the analysis in a short time.

According to the battery inspection method of the present disclosure, it is possible to inspect a state of occurrence of microcracks in the electrodes of the battery in about seven (7) minutes without destroying the battery.

## Claims

**1.** A battery inspection method comprising provision of a secondary battery and comprising:

a data acquisition step S10 of acquiring impedance spectral data for the secondary battery;
a first function acquisition step S20 of acquiring, through function fitting, a first function which uses a logarithmic scale of a measurement frequency as an independent variable and an absolute value of impedance as a dependent variable from the impedance spectral data;
a second function acquisition step S30 of acquiring a second function by differentiating the first function by the logarithmic scale of the measurement frequency; and
a battery state determination step S40 of determining a state of the secondary battery based on the second function.

**2.** The battery inspection method of claim 1, wherein, in the data acquisition step S10, the impedance spectral data is acquired by applying alternating current power to the secondary battery for a band of the measurement frequency including a band of $10^{-2}$ Hz to $10^5$ Hz.

**3.** The battery inspection method of claim 1, wherein, in the first function acquisition step S20, the first function is acquired in the form of the following Equation 1:

[Equation 1]

$$Z_{abs} = F_1(\log f)$$

wherein $Z_{abs}$ is the absolute value of the impedance, $F_1(\log f)$ is the first function, and f is the measurement frequency.

**4.** The battery inspection method of claim 3, wherein the second function is acquired in the form of the following Equation 2:

[Equation 2]

$$F_2(\log f) = \frac{dZ_{abs}}{d\log f}$$

wherein $F_2$(logf) is the second function.

5. The battery inspection method of claim 4, wherein, in the battery state determination step S40, the state of the secondary battery is determined based on the second function in a range where the logf is 0 to 1.

6. The battery inspection method of claim 5, wherein, in the battery state determination step S40, when an inflection point exists in the second function in the range where the logf is 0 to 1, it is determined that cracks occur in electrodes of the secondary battery.

7. The battery inspection method according to claim 4, wherein no inflection point exists in the second function in a range where the logf is 0 to 1.

**Patentansprüche**

1. Batterieinspektionsverfahren umfassend Bereitstellen einer Sekundärbatterie, und ferner umfassend:

   einen Datenerfassungsschritt S10 zum Erfassen von Impedanzspektraldaten für die Sekundärbatterie;
   einen ersten Funktionserfassungsschritt S20 zum Erfassen, durch Funktionsanpassung, einer ersten Funktion, die eine logarithmische Skala einer Messfrequenz als eine unabhängige Variable und einen Absolutwert der Impedanz als eine abhängige Variable verwendet, aus den Impedanzspektraldaten;
   einen zweiten Funktionserfassungsschritt S30 zum Erfassen einer zweiten Funktion durch Differenzieren der ersten Funktion durch die logarithmische Skala der Messfrequenz; und
   einen Batteriezustandsbestimmungsschritt S40 zum Bestimmen eines Zustands der Sekundärbatterie basierend auf der zweiten Funktion.

2. Batterieinspektionsverfahren nach Anspruch 1, wobei, in dem Datenerfassungsschritt S10, die Impedanzspektraldaten erfasst werden durch Anlegen von Wechselstrom an die Sekundärbatterie für ein Band der Messfrequenz einschließlich eines Bandes von $10^{-2}$ Hz bis $10^5$ Hz.

3. Batterieinspektionsverfahren nach Anspruch 1, wobei, in dem ersten Funktionserfassungsschritt S20, die erste Funktion in Form der folgenden Gleichung 1 erfasst wird:

   [Gleichung 1]

$$Z_{abs} = F_1(\log f)$$

   wobei $Z_{abs}$ der Absolutwert der Impedanz ist, $F_1(\log f)$ die erste Funktion ist und $f$ die Messfrequenz ist.

4. Batterieinspektionsverfahren nach Anspruch 3, wobei die zweite Funktion in Form der folgenden Gleichung 2 erfasst wird:

   [Gleichung 2]

$$F_2(\log f) = \frac{dZ_{abs}}{d\log f}$$

   wobei $F_2$(logf) die zweite Funktion ist.

5. Batterieinspektionsverfahren nach Anspruch 4, wobei, in dem Batteriezustandsbestimmungsschritt S40, der Zustand der Sekundärbatterie basierend auf der zweiten Funktion in einem Bereich bestimmt wird, in dem der log*f* 0 bis 1 ist.

6. Batterieinspektionsverfahren nach Anspruch 5, wobei, in dem Batteriezustandsbestimmungsschritt S40, wenn ein Wendepunkt in der zweiten Funktion in dem Bereich existiert, in dem der log*f* 0 bis 1 ist, bestimmt wird, dass Risse in Elektroden der Sekundärbatterie auftreten.

7. Batterieinspektionsverfahren nach Anspruch 4, wobei kein Wendepunkt in der zweiten Funktion in einem Bereich existiert, in dem der log *f* 0 bis 1 ist.

**Revendications**

1. Procédé d'inspection de batterie comprenant la fourniture d'une batterie rechargeable et comprenant :

   une étape d'acquisition de données S10 consistant à acquérir des données de spectre d'impédance pour la batterie rechargeable ;
   une étape d'acquisition de première fonction S20 consistant à acquérir, par l'intermédiaire d'un ajustement de fonction, une première fonction qui emploie une échelle logarithmique d'une fréquence de mesure en tant que variable indépendante et une valeur d'impédance absolue en tant que variable dépendante, à partir des données de spectre d'impédance ;
   une étape d'acquisition de deuxième fonction S30 consistant à acquérir une deuxième fonction en différentiant la première fonction par l'échelle logarithmique de la fréquence de mesure ; et
   une étape de détermination d'état de batterie S40 consistant à déterminer un état de la batterie rechargeable sur la base de la deuxième fonction.

2. Procédé d'inspection de batterie selon la revendication 1, dans lequel, à l'étape d'acquisition de données S10, les données de spectre d'impédance sont acquises en appliquant une alimentation en courant alternatif à la batterie rechargeable pour une bande de la fréquence de mesure incluant une bande de $10^{-2}$ Hz à $10^5$ Hz.

3. Procédé d'inspection de batterie selon la revendication 1, dans lequel, à l'étape d'acquisition de première fonction S20, la première fonction est acquise sous la forme de l'Équation 1 ci-après :

   [Équation 1]

   $$Z_{abs} = F_1(\log f)$$

   où $Z_{abs}$ est la valeur absolue de l'impédance, $F_1(\log f)$ est la première fonction et f est la fréquence de mesure.

4. Procédé d'inspection de batterie selon la revendication 3, dans lequel la deuxième fonction est acquise sous la forme de l'Équation 2 ci-après :

   [Équation 2]

   $$F_2(\log f) = \frac{dZ_{abs}}{d\log f}$$

   où $F_2(\log f)$ est la deuxième fonction.

5. Procédé d'inspection de batterie selon la revendication 4, dans lequel, à l'étape de détermination d'état de batterie S40, l'état de la batterie rechargeable est déterminé sur la base de la deuxième fonction dans une plage où logf est 0 à 1.

**6.** Procédé d'inspection de batterie selon la revendication 5, dans lequel, à l'étape de détermination d'état de batterie S40, quand un point d'inflexion existe dans la deuxième fonction dans la plage où logf est 0 à 1, il est déterminé que des fissures se sont produites dans les électrodes de la batterie rechargeable.

**7.** Procédé d'inspection de batterie selon la revendication 4, dans lequel aucun point d'inflexion n'existe dans la deuxième fonction dans une plage où logf est 0 à 1.

FIG. 1

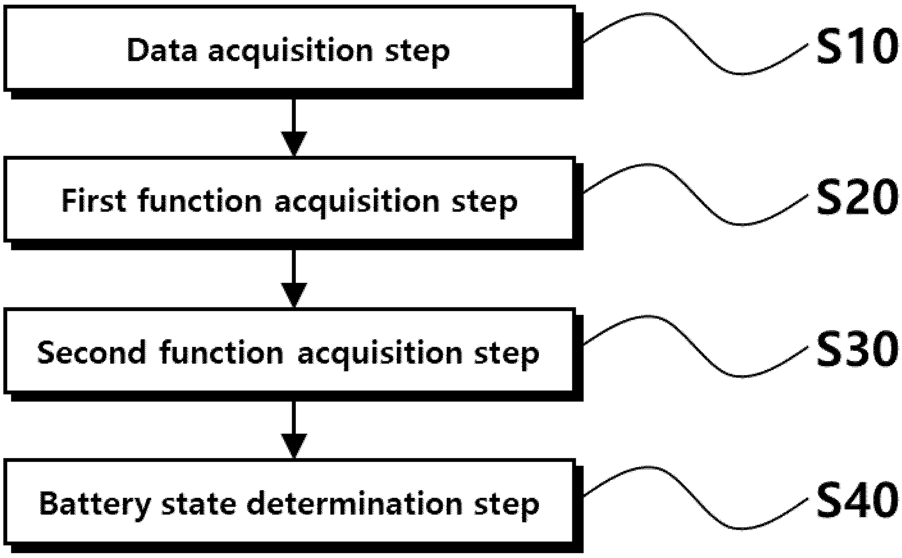
Data acquisition step
First function acquisition step
Second function acquisition step
Battery state determination step
S10
S20
S30
S40

FIG. 2

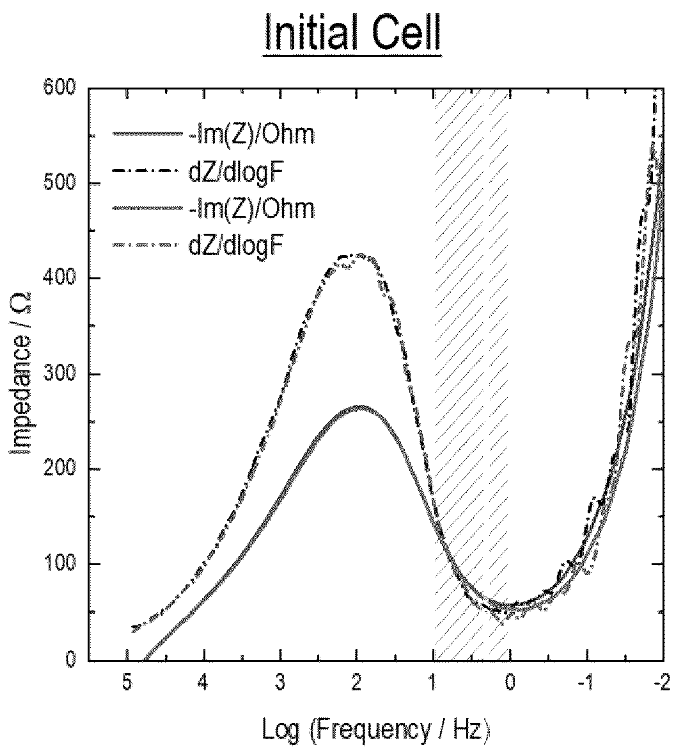
Initial Cell
-Im(Z)/Ohm
dZ/dlogF
-Im(Z)/Ohm
dZ/dlogF
Impedance / Ω
Log (Frequency / Hz)
0
100
200
300
400
500
600
5
4
3
2
1
0
-1
-2

FIG. 3

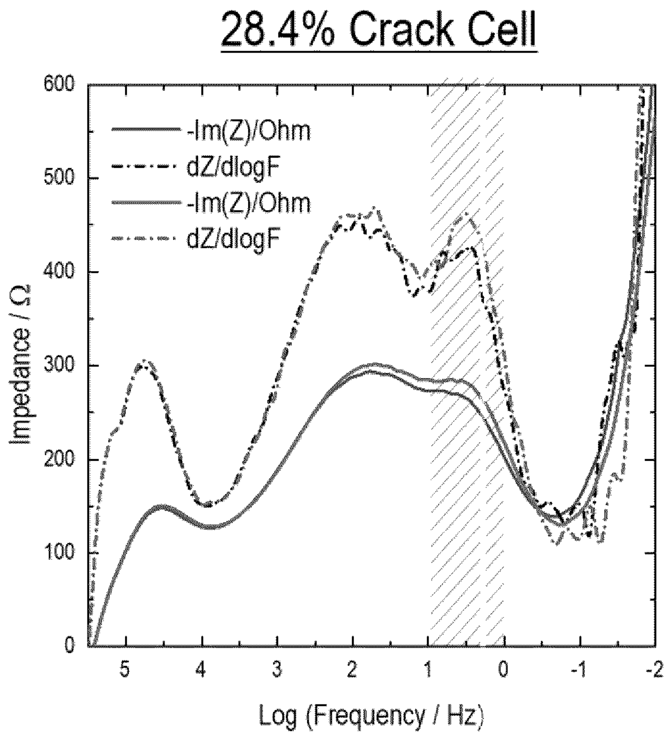
28.4% Crack Cell
-Im(Z)/Ohm
dZ/dlogF
-Im(Z)/Ohm
dZ/dlogF
Impedance / Ω
Log (Frequency / Hz)
600
500
400
300
200
100
0
5
4
3
2
1
0
-1
-2

FIG. 4

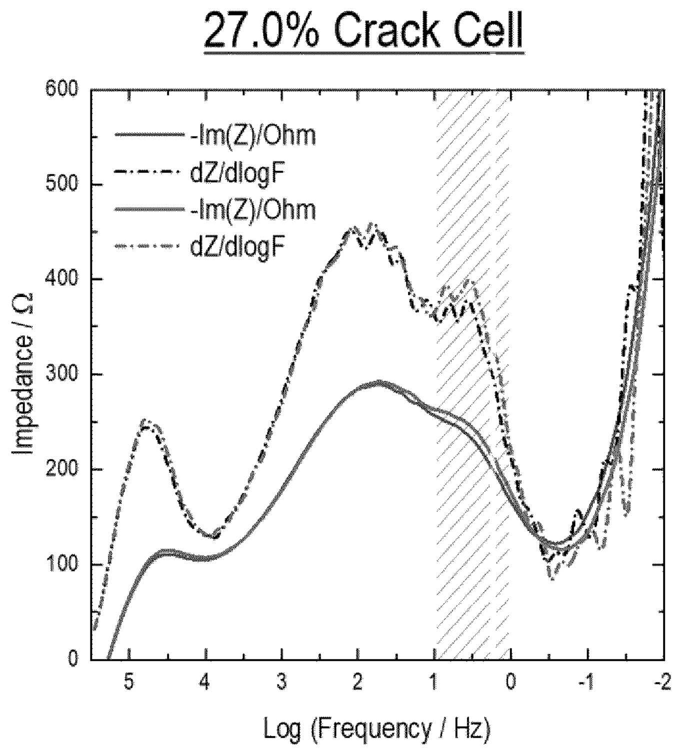
27.0% Crack Cell
-Im(Z)/Ohm
dZ/dlogF
-Im(Z)/Ohm
dZ/dlogF
Impedance / Ω
Log (Frequency / Hz)
600
500
400
300
200
100
0
5
4
3
2
1
0
-1
-2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020220175754
- US 2017219660 A1